# EUROPÄISCHE PATENTANMELDUNG

(11) **EP 3 503 700 A1**
(43) Veröffentlichungstag der Anmeldung: **26.06.2019**
(21) Anmeldenummer: 17208484.0
(22) Anmeldetag: 19.12.2017
(51) Int. Cl.: H05K 7/20

(54) **ANZEIGEVORRICHTUNG FÜR ZUGANGSKONTROLLVORRICHTUNGEN, VERKAUFS- UND BEZAHLAUTOMATEN UND DIGITAL-SIGNAGE-VORRICHTUNGEN**

(71) Anmelder: SKIDATA AG, 5083 Grödig/Salzburg (AT)
(72) Erfinder: Reichartzeder, Simon, 5165 Berndorf (AT); Stumpfl, Bernhard, 5020 Salzburg (AT)
(74) Vertreter: Karakatsanis, Georgios

(57) **Zusammenfassung**

Es wird eine Anzeigevorrichtung (1) für Zugangskontrollvorrichtungen, Verkaufs- und Bezahlautomaten sowie Digital-Signage-Vorrichtungen, umfassend ein Display (2) mit elektronischen Komponenten, dessen dem Betrachter zugewandte Seite mit einer Frontscheibe (3) aus transparentem Material verbunden ist, vorgeschlagen, wobei parallel zu der Frontscheibe (3) in einem definierten Abstand eine weitere Scheibe (4) aus transparentem Material angeordnet ist, derart, dass durch die Frontscheibe (3), die weitere Scheibe (4) aus transparentem Material und die miteinander verklebten Ränder beider Scheiben (3, 4) ein quaderförmiger Hohlraum (5) gebildet wird, der vollständig mit einer transparenten Flüssigkeit befüllbar ist, welche mittels eines geschlossenen Fluidkreislaufs umfassend eine Pumpe (6), eine Steuerung (7), Mittel zur Erfassung und Mittel zur Einstellung der Temperatur der Flüssigkeit über einen Fluideinlass (8) und einen Fluidauslass (9) umgewälzt wird, um eine vorgegebene Temperatur der sich im Hohlraum (5) befindenden Flüssigkeit zu gewährleisten.

## Beschreibung

Die Erfindung bezieht sich auf eine Anzeigevorrichtung für Zugangskontrollvorrichtungen, Verkaufs- und Bezahlautomaten und Digital-Signage-Vorrichtungen gemäß dem Oberbegriff des Patentanspruchs 1.

Zugangskontrollvorrichtungen, Verkaufs- und Bezahlautomaten sowie Digital-Signage-Vorrichtungen werden oft im Freien aufgestellt, wodurch sie unterschiedlichen Wetterbedingungen ausgesetzt sind. Hierbei kann es bei hohen oder niedrigen Temperaturen oder bei direkter Sonneneinstrahlung in nachteiliger Weise zu Beeinträchtigungen der Qualität der Anzeige der in Zugangskontrollvorrichtungen, Verkaufs- und Bezahlautomaten sowie Digital-Signage-Vorrichtungen integrierten Anzeigevorrichtungen, welche ein elektronische Komponenten, welche ein Bild wiedergeben enthaltendes Display aufweisen, vor dem in Richtung auf die Betrachter der Anzeigevorrichtung eine Frontscheibe angeordnet ist. Insbesondere kann bei hohen Außentemperaturen oder direkter Sonneneinstrahlung das elektronische Komponenten enthaltende Display der Anzeigevorrichtung beschädigt werden.

Aus dem Stand der Technik ist bekannt, Anzeigevorrichtungen für Bezahl- und Verkaufsautomaten mittels eines Lüfters und geeigneter Luftheiz- und/oder Luftkühlvorrichtungen mit warmer bzw. kühler Luft zu versorgen. Hierbei ist es jedoch nicht möglich, den hinsichtlich des Temperatureinflusses kritischen Bereich, nämlich die den Betrachtern zugewandte Frontscheibe der Anzeigevorrichtung, hinter der das Display angeordnet ist und die in der Regel aus Glas hergestellt ist, gleichmäßig und vollständig zu beheizen oder zu kühlen; zudem kann die Strömung der warmen oder kalten Luft in Richtung auf die Frontscheibe aufgrund der jeweils herrschenden Wetterbedingungen negativ beeinträchtigt werden.

Der vorliegenden Erfindung liegt die Aufgabe zugrunde, eine Anzeigevorrichtung für Zugangskontrollvorrichtungen, Verkaufs- und Bezahlautomaten sowie Digital-Signage-Vorrichtungen anzugeben, welche bei hohen Temperaturen, direkter Sonneneinstrahlung und niedrigen Temperaturen ohne die Gefahr einer temperaturbedingten Beschädigung betrieben werden kann.

Diese Aufgabe wird durch die Merkmale des Patentanspruchs 1 gelöst. Weitere erfindungsgemäße Ausgestaltungen und Vorteile gehen aus den Unteransprüchen hervor.

Demnach wird eine Anzeigevorrichtung für Zugangskontrollvorrichtungen, Verkaufs- und Bezahlautomaten sowie Digital-Signage-Vorrichtungen vorgeschlagen, umfassend ein Display mit elektronischen Komponenten, dessen dem Betrachter zugewandte Seite mit einer Frontscheibe aus transparentem Material verbunden ist, bei der parallel zu der Frontscheibe in einem definierten Abstand eine weitere Scheibe aus transparentem Material angeordnet ist, derart, dass durch die Frontscheibe, die weitere Scheibe aus transparentem Material und die miteinander verklebten Ränder beider Scheiben ein quaderförmiger Hohlraum gebildet wird, der vollständig mit einer transparenten Flüssigkeit befüllbar ist, die mittels eines geschlossenen Fluidkreislaufs umfassend eine Pumpe, eine Steuerung, Mittel zur Erfassung und Mittel zur Einstellung der Temperatur der Flüssigkeit über einen Fluideinlass und einen Fluidauslass umgewälzt wird, um eine vorgegebene Temperatur der sich im Hohlraum befindenden Flüssigkeit zu gewährleisten.

Durch Einstellen und Erreichen einer vorgegebenen Temperatur der Flüssigkeit wird ja nach Bedarf das Display gekühlt oder beheizt.

Hierbei kann zur genaueren Ermittlung der Temperatur der Flüssigkeit im Hohlraum zum Zweck der Steuerung am Fluideinlass und am Fluidauslass jeweils ein Temperatursensor vorgesehen sein.

Vorzugsweise befinden sich der Fluideinlass und der Fluidauslass an diametral gegenüberliegenden Seitenflächen des gebildeten quaderförmigen Hohlraums, die senkrecht zu der Frontscheibe und der weiteren Scheibe aus transparentem Material verlaufen.

Die transparente Flüssigkeit kann beispielsweise Ethanol oder eine weitere geeignete transparente Flüssigkeit mit einem niedrigen Brechungsindex sein. Vorzugsweise wird die transparente Flüssigkeit derart langsam umgewälzt, dass die Flüssigkeit um Hohlraum nicht wahrgenommen werden kann. Im Rahmen einer Weiterbildung wird vorgeschlagen, den Fluideinlass und den Fluidauslass des gebildeten Hohlraumes derart zu gestalten, dass die Flüssigkeit über im Wesentlichen die gesamte Fläche der Seite, an der der Fluideinlass und den Fluidauslass jeweils angeordnet sind in den Hohlraum hinein- bzw. aus dem Hohlraum hinausfließt.

Beispielsweise können der Fluideinlass und der Fluidauslass trichterförmig ausgeführt sein, wobei die den Seiten des Hohlraums, an denen der Fluideinlass und den Fluidauslass jeweils angeordnet sind, abgewandte Seiten der Trichter durch die Trichterhälse gebildet sind, die jeweils mit der Zuflussleitung und der Abflussleitung des Fluidkreislaufs verbunden sind. Dadurch wird eine gleichmäßige Verteilung und somit eine geringe Strömungsgeschwindigkeit der Flüssigkeit erzielt, so dass die Flüssigkeit zwischen den beiden Scheiben nicht wahrgenommen werden kann.

Gemäß einer vorteilhaften Weiterbildung der Erfindung wird die Temperatur der Flüssigkeit mittels eines Peltier-Elementes eingestellt bzw. gesteuert; zur Steuerung der Temperatur können im Rahmen weiterer Ausgestaltungen weitere geeignete Bauteile verwendet werden.

Gemäß der Erfindung kann ein mit dem Fluidkreislauf über ein entsprechendes Ventil fluidtechnisch verbindbarer Druckausgleichsbehälter vorgesehen sein, um den Druck innerhalb des Fluidkreislaufs auf einen vorgegebenen Wert konstant zu halten. Hierbei kann das Ventil mit der Steuerung verbunden sein, wobei die Ventilstellung anhand der Temperatur der Flüssigkeit, beispielweise über eine in der Steuerung abgelegte Kennlinie gesteuert wird.

Die weitere Scheibe aus transparentem Material kann aus Glas, aus Acrylglas oder aus jedem geeigneten transparenten Material hergestellt sein.

Die Anordnung der weiteren Scheibe aus transparentem Material über der Frontscheibe kann nach dem Stand der Technik beispielsweise mittels optical bonding erfolgen, wobei ein Kleber nur an den Rändern beider Scheiben vorgesehen ist, derart, dass nach Abschluss des Bonding-Verfahrens die weitere Scheibe aus transparentem Material in einem definierten Abstand über der Frontscheibe angeordnet ist.

Durch die erfindungsgemäße Konzeption wird eine Anzeigevorrichtung für Zugangskontrollvorrichtungen, Verkaufs- und Bezahlautomaten sowie Digital-Signage-Vorrichtungen zur Verfügung gestellt, welche eine Steuerung der Temperatur direkt am Display ermöglicht. In vorteilhafter Weise kann dadurch das Display auch bei sehr tiefen Temperaturen sehr schnell mit warmer Flüssigkeit versorgt werden, was einen reibungslosen Betrieb gewährleistet. Zudem ist mittels der erfindungsgemäße Konzeption möglich, sehr große Anzeigevorrichtungen auch bei direkter Sonneneinstrahlung sicher zu betreiben.

Ferner können bestehende Anzeigevorrichtungen mit geringem Aufwand nachgerüstet werden.

Die Erfindung wird im Folgenden anhand der beigefügten Figuren beispielhaft näher erläutert. Es zeigen:
Figur 1: eine schematische Schnittansicht Ansicht einer gemäß der Erfindung ausgeführten Anzeigevorrichtung; und
Figur 2: eine weitere schematische Schnittansicht Ansicht einer gemäß der Erfindung ausgeführten Anzeigevorrichtung zur Veranschaulichung einer Ausgestaltung des Fluideinlasses und des Fluidauslasses.

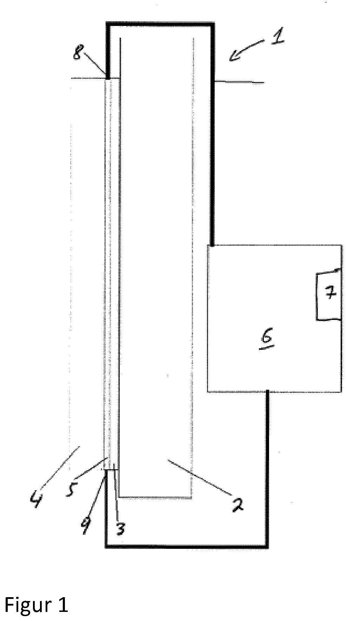

In Figur 1 ist eine Anzeigevorrichtung 1 für Zugangskontrollvorrichtungen, Verkaufs- und Bezahlautomaten sowie Digital-Signage-Vorrichtungen dargestellt, umfassend ein Display 2 mit elektronischen Komponenten, dessen dem Betrachter zugewandte Seite mit einer Frontscheibe 3 aus transparentem Material verbunden ist.

Gemäß der Erfindung ist parallel zu der Frontscheibe 3 in einem definierten Abstand eine weitere Scheibe 4 aus transparentem Material angeordnet, derart, dass sich durch die Frontscheibe 3, die weitere Scheibe 4 aus transparentem Material und die miteinander verklebten Ränder beider Scheiben 3, 4 ein quaderförmiger Hohlraum 5 bildet, der vollständig mit einer transparenten Flüssigkeit befüllbar ist, welche mittels eines geschlossenen Fluidkreislaufs umfassend eine Pumpe 6, eine Steuerung 7, Mittel zur Erfassung und Mittel zur Einstellung der Temperatur der Flüssigkeit über einen Fluideinlass 8 und einen Fluidauslass 9 umgewälzt wird, um eine vorgegebene Temperatur der sich im Hohlraum 5 befindenden Flüssigkeit zu gewährleisten. Zur genaueren Ermittlung der Temperatur der Flüssigkeit im Hohlraum 5 ist am Fluideinlass 8 und am Fluidauslass 9 jeweils ein Temperatursensor vorgesehen. Der Hohlraum 5 ist stets vollständig befüllt.

Wie aus Figur 1 ersichtlich sind der Fluideinlass 8 und der Fluidauslass 9 an diametral gegenüberliegenden Seitenflächen des gebildeten quaderförmigen Hohlraums 5 angeordnet, welche senkrecht zu der Frontscheibe 3 und der weiteren Scheibe 4 aus transparentem Material verlaufen.

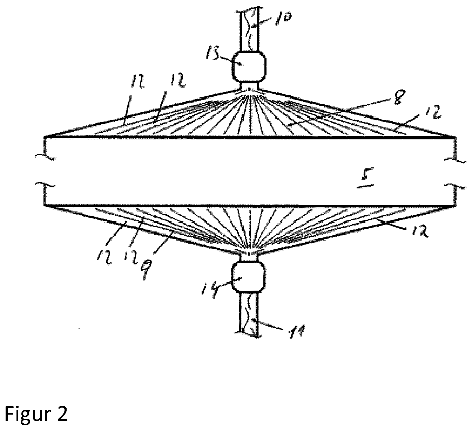

In Figur 2 ist eine Ausgestaltung des Fluideinlasses 8 und des Fluidauslasses 9 dargestellt. Hierbei sind der Fluideinlass 8 und der Fluidauslass 9 des gebildeten Hohlraumes 5 derart gestaltet, dass die Flüssigkeit über im Wesentlichen die gesamte Fläche der Seite, an der Fluideinlass 8 und der Fluidauslass 9 jeweils angeordnet sind in den Hohlraum 5 hinein- bzw. aus dem Hohlraum 5 hinausfließt. Dadurch kann die Strömung der Flüssigkeit nicht wahrgenommen werden.

Wie aus Figur 2 ersichtlich, sind der Fluideinlass 8 und der Fluidauslass 9 trichterförmig ausgeführt, wobei die den Seiten des Hohlraums 5, an denen der Fluideinlass 8 und den Fluidauslass 9 jeweils angeordnet sind, abgewandten Seiten der Trichter durch die Trichterhälse gebildet sind, die jeweils mit der Zuflussleitung 10 und der Abflussleitung 11 des Fluidkreislaufs verbunden sind. Dadurch wird eine gleichmäßige Verteilung der Flüssigkeit erzielt, so dass die Flüssigkeit zwischen den beiden Scheiben 3, 5 nicht wahrgenommen werden kann. Bei dem gezeigten Beispiel weisen die Trichter sich vom Trichterhals zum Hohlkörper 5 hin erstreckende Rippen 12 auf, um die gleichmäßige Verteilung der Flüssigkeit zu optimieren. Ferner ist zur genaueren Ermittlung der Temperatur der Flüssigkeit im Hohlraum 5 am Fluideinlass 8 und am Fluidauslass 9 jeweils ein Temperatursensor 13, 14 vorgesehen; die Temperatursensoren sind mit der Steuerung verbunden.

Bei den in Figuren 1 und 2 gezeigten Beispielen ist der Fluideinlass 8 an der oberen Seitenfläche des gebildeten quaderförmigen Hohlraums 5, die senkrecht zu der Frontscheibe 3 und der weiteren Scheibe 5 aus transparentem Material verläuft angeordnet, wobei der Fluidauslass 8 an der gegenüberliegenden Seite des Hohlraums 5 angeordnet ist.

## Patentansprüche

1. Anzeigevorrichtung (1) für Zugangskontrollvorrichtungen, Verkaufs- und Bezahlautomaten sowie Digital-Signage-Vorrichtungen, umfassend ein Display (2) mit elektronischen Komponenten, dessen dem Betrachter zugewandte Seite mit einer Frontscheibe (3) aus transparentem Material verbunden ist, **dadurch gekennzeichnet, dass** parallel zu der Frontscheibe (3) in einem definierten Abstand eine weitere Scheibe (4) aus transparentem Material angeordnet ist, derart, dass durch die Frontscheibe (3), die weitere Scheibe (4) aus transparentem Material und die miteinander verklebten Ränder beider Scheiben (3, 4) ein quaderförmiger Hohlraum (5) gebildet wird, der vollständig mit einer transparenten Flüssigkeit befüllbar ist, welche mittels eines geschlossenen Fluidkreislaufs umfassend eine Pumpe (6), eine Steuerung (7), Mittel zur Erfassung und Mittel zur Einstellung der Temperatur der Flüssigkeit über einen Fluideinlass (8) und einen Fluidauslass (9) umgewälzt wird, um eine vorgegebene Temperatur der sich im Hohlraum (5) befindenden Flüssigkeit zu gewährleisten.

2. Anzeigevorrichtung (1) für Zugangskontrollvorrichtungen, Verkaufs- und Bezahlautomaten sowie Digital-Signage-Vorrichtungen, nach Anspruch 1, **dadurch gekennzeichnet, dass** der Fluideinlass und der Fluidauslass an diametral gegenüberliegenden Seitenflächen des gebildeten quaderförmigen Hohlraums (5) angeordnet sind, die senkrecht zu der Frontscheibe (3) und der weiteren Scheibe (4) aus transparentem Material verlaufen.

3. Anzeigevorrichtung (1) für Zugangskontrollvorrichtungen, Verkaufs- und Bezahlautomaten sowie Digital-Signage-Vorrichtungen, nach Anspruch 1 oder 2, **dadurch gekennzeichnet, dass** der Fluideinlass (8) und der Fluidauslass (9) des gebildeten Hohlraumes (5) derart ausgeführt ist, dass die Flüssigkeit über im Wesentlichen die gesamte Fläche der Seite, an der der Fluideinlass (8) und der Fluidauslass (9) jeweils angeordnet sind in den Hohlraum (5) hinein- bzw. aus dem Hohlraum (5) hinausfließt.

4. Anzeigevorrichtung (1) für Zugangskontrollvorrichtungen, Verkaufs- und Bezahlautomaten sowie Digital-Signage-Vorrichtungen, nach Anspruch 3, **dadurch gekennzeichnet, dass** der Fluideinlass (8) und der Fluidauslass (9) trichterförmig ausgeführt sind, wobei die den Seiten des Hohlraums (5), an denen der Fluideinlass (8) und den Fluidauslass (9) jeweils angeordnet sind, abgewandte Seiten der Trichter durch die Trichterhälse gebildet sind, die jeweils mit einer Zuflussleitung (10) und einer Abflussleitung (11) des Fluidkreislaufs verbunden sind.

5. Anzeigevorrichtung (1) für Zugangskontrollvorrichtungen, Verkaufs- und Bezahlautomaten sowie Digital-Signage-Vorrichtungen, nach Anspruch 4, **dadurch gekennzeichnet, dass** die Trichter sich vom Trichterhals zum Hohlkörper (5) hin erstreckende Rippen (12) aufweisen.

6. Anzeigevorrichtung (1) für Zugangskontrollvorrichtungen, Verkaufs- und Bezahlautomaten sowie Digital-Signage-Vorrichtungen, nach einem der vorangehenden Ansprüche, **dadurch gekennzeichnet, dass** die Temperatur der Flüssigkeit mittels eines Peltier-Elementes eingestellt bzw. gesteuert wird.

7. Anzeigevorrichtung (1) für Zugangskontrollvorrichtungen, Verkaufs- und Bezahlautomaten sowie Digital-Signage-Vorrichtungen, nach einem der vorangehenden Ansprüche, **dadurch gekennzeichnet, dass** zur genaueren Ermittlung der Temperatur der Flüssigkeit im Hohlraum (5) zum Zweck der Steuerung am Fluideinlass (8) und am Fluidauslass (9) jeweils ein Temperatursensor vorgesehen ist.

8. Anzeigevorrichtung (1) für Zugangskontrollvorrichtungen, Verkaufs- und Bezahlautomaten sowie Digital-Signage-Vorrichtungen, nach einem der vorangehenden Ansprüche, **dadurch gekennzeichnet, dass** die transparente Flüssigkeit Ethanol oder eine weitere transparente Flüssigkeit mit niedrigem Brechungsindex ist.

9. Anzeigevorrichtung (1) für Zugangskontrollvorrichtungen, Verkaufs- und Bezahlautomaten sowie Digital-Signage-Vorrichtungen, nach einem der vorangehenden Ansprüche, **dadurch gekennzeichnet, dass** sie einen mit dem Fluidkreislauf über ein Ventil fluidtechnisch verbindbaren Druckausgleichsbehälter aufweist, um den Druck innerhalb des Fluidkreislaufs auf einen vorgegebenen Wert konstant zu halten.

10. Anzeigevorrichtung (1) für Zugangskontrollvorrichtungen, Verkaufs- und Bezahlautomaten sowie Digital-Signage-Vorrichtungen, nach Anspruch 9, **dadurch gekennzeichnet, dass** das Ventil mit der Steuerung verbunden ist, wobei die Ventilstellung anhand der Temperatur der Flüssigkeit gesteuert wird.

11. Anzeigevorrichtung (1) für Zugangskontrollvorrichtungen, Verkaufs- und Bezahlautomaten sowie Digital-Signage-Vorrichtungen, nach einem der vorangehenden Ansprüche, **dadurch gekennzeichnet, dass** die weitere Scheibe (4) aus transparentem Material aus Glas, aus Acrylglas oder aus jedem geeigneten transparenten Material hergestellt ist.
